# EUROPÄISCHE PATENTSCHRIFT

(11) **EP 0 520 324 B1**
(45) Veröffentlichungstag und Bekanntmachung des Hinweises auf die Patenterteilung: **14.09.1994**
(21) Anmeldenummer: 92110315.6
(22) Anmeldetag: 18.06.1992
(51) Int. Cl.: H05K 3/00, C25F 7/00

(54) **Vorrichtung zum Behandeln von plattenförmigen Gegenständen, insbesondere Leiterplatten**
Apparatus for treating panel-type objects, especially circuit boards
Appareils pour traiter des objets de panneau, notamment des plaques de circuit

(30) Priorität: 26.06.1991 DE 4121032
(43) Veröffentlichungstag der Anmeldung: 30.12.1992
(73) Patentinhaber: Gebr. Schmid GmbH & Co., D-72250 Freudenstadt (DE)
(72) Erfinder: Schmid, Christian, W-7290 Freudenstadt (DE)
(74) Vertreter: Patentanwälte Ruff, Beier, Schöndorf und Mütschele

(56) Entgegenhaltungen:
- EP-A- 0 320 482
- DE-A- 2 619 821
- DE-A- 3 813 518

## Beschreibung

Die Erfindung betrifft eine Vorrichtung zum Behandeln von plattenförmigen Gegenständen, insbesondere Leiterplatten, mit einem fluiden Behandlungsmedium, insbesondere einer Reinigungs-Ätz-, Metallisierungs- bzw. Spülflüssigkeit, mit einer Transportvorrichtung zum Transport der Gegenstände entlang eines gegebenenfalls im wesentlichen horizontalen Transportweges und mit wenigstens einer Auftragvorrichtung, insbesondere einer Sprüh- oder Schwalldüse oder mit einer Vorrichtung, die eine stehende Welle erzeugt, zum Aufbringen des Behandlungsmediums auf die Plattenoberfläche. Ein solche Vorrichtung ist aus DE-A- 3 813 518 bekannt.

Solche Vorrichtungen können in breitem Maße insbesondere für die Herstellung von elektrischen Leiterplatten verwendet werden.

Mit zunehmender Integrationsdichte der Bauteile und der Bauteile auf den Leiterplatten wird eine ständige Verringerung der Leiterbahnenbreite und des Abstandes der Leiterbahnen untereinander notwendig. Je kleiner die Dimensionierung der Leiterbahnen ausfällt desto wichtiger wird es, ein Unterätzen der Leiterbahnen zu verhindern. Auch bei einer ganzen Reihe anderer Behandlungsschritte für Leiterplatten wird es zunehmend bedeutungsvoll, das Behandlungsmedium über einen exakt steuerbaren Zeitraum auf die Plattenoberflächen einwirken zu lassen. Im Sinne eines größtmöglichen Durchsatzes spielt die Behandlungszeit pro Plattenoberfläche ebenfalls eine Rolle, so daß eine möglichst kurzzeitige Behandlungsdauer der Leiterplattenoberfläche angestrebt wird. Gleichzeitig soll das Behandlungsergebnis eine konstante Qualität aufweisen, und es muß insbesondere sichergestellt sein, daß die Zwischenräume zwischen den Leiterbahnen keine restliche Kupferkaschierung mehr aufweisen.

Diese Aspekte werden noch wichtiger im Hinblick auf die Herstellung von Multi-Layer-Platinen, bei denen erst nach dem Zusammenfügen einer Vielzahl von einzelnen elektronischen Leiterplatten die Gesamtplatine erhalten wird und erst dann auf Funktionsfähigkeit getestet werden kann.

Die Fehlermöglichkeiten multiplizieren sich mit der Zahl der Schichten und gleichzeitig vervielfacht sich der Schaden beim Ausfall einer Leiterplatte.

Vor diesem Hintergrund liegt der Erfindung die Aufgabe zugrunde, Nachteile bekannter Ausbildungen bzw. der beschriebenen Art zu verringern und insbesondere eine Vorrichtung zum Behandeln von plattenförmigen Gegenständen der beschriebenen Art so auszubilden, daß die Plattenoberfläche einer zeitlich genau begrenzbaren und im zeitlichen Mittel auch konstanten Behandlung mit einem Behandlungsmedium unterzogen werden kann.

Diese Aufgabe wird bei einer Vorrichtung der eingangs beschriebenen Art erfindungsgemäß durch die im kennzeichnenden Teil des Anspruches 1 definierten mittel gelöst. In Transportrichtung gesehen können vor bzw. nach der Auftragvorrichtung Begrenzungs-bzw. Absaugvorrichtungen mit der Plattenoberfläche zugewandten und im wesentlichen über die gesamte Breite des Transportweges reichenden Durchlaß-bzw. Ansaugöffnungen oder dergleichen angeordnet sein, durch welche ein Oberflächenbereich der Platte, der zu einem Zeitpunkt mit dem Behandlungsmedium in Kontakt steht, in seiner Ausdehnung längs der Transportrichtung vordefinierbar und begrenzbar ist.

Die Anordnung der Auftragvorrichtung zwischen den beiden Absaugvorrichtungen in Transportrichtung gesehen bringt den Vorteil mit sich, daß das Behandlungsmedium parallel zur Transportrichtung entlang der Plattenoberfläche transportiert wird, wobei der zu einem jeweiligen Zeitpunkt behandelte Oberflächenbereich der Platte durch die Absaugvorrichtungen bzw. deren Ansaugöffnungen exakt begrenzbar ist.

Gleichzeitig findet auf der Plattenoberfläche durch die aufgezwungene Strömung des Mediums ein intensiver Flüssigkeitsaustausch statt, so daß für den Behandlungsschritt stets unverbrauchtes Medium nachgeliefert wird. Dies garantiert nicht nur ein gleichbleibend gutes Behandlungsergebnis, sondern verkürzt die notwendige Behandlungszeit auf ein Minimum.

Damit lassen sich äußerst exakt zeitlich bestimmbare Behandlungsschritte durchführen und Probleme, wie zum Beispiel ein merkliches Unterätzen von Leiterbahnen, vermeiden.

Insbesondere bei der Behandlung der oben liegenden Plattenoberflächen ergaben sich früher immer wieder Probleme durch nicht beseitigte Behandlungsmediumreste, die, anders als bei der Unterseite, für einen relativ langen Zeitraum noch in Kontakt mit der Plattenoberfläche bleiben, während bei der Unterseite in der Regel die überschüssige Behandlungsflüssigkeit abtropft.

Deshalb wurde zum Teil vorgeschlagen, die Leiterplatten stets nur einseitig, und zwar an der Unterseite, zu behandeln und dann zu wenden. Diesem Problem kann die vorliegende Erfindung zumindest in einer Vielzahl von Fällen abhelfen, wodurch sich die Herstellung von Leiterplatten, die höchste Genauigkeit in der Behandlung erfordern, vereinfachen und beschleunigen läßt.

Bei der erfindungsgemäßen Vorrichtung ist es zunächst von geringerer Bedeutung, ob die Behandlungsflüssigkeit mittels Sprüh- oder Schwalldüsen aufgebracht wird oder mittels einer stehenden Welle, wobei unter einer stehenden Welle ein konstant wieder aufgefülltes Flüssigkeitsvolumen verstanden wird, durch das die Leiterplatte mit einer Oberfläche oder beiden Oberflächen hindurchtransportiert wird.

Aus Gründen des Spritzschutzes und der höheren Effizienz der Absaugvorrichtungen empfiehlt es sich, die Auftragvorrichtung und die Absaugvorrichtungen in einem gemeinsamen Gehäuse anzuordnen.

An dem Gehäuse werden vorteilhafterweise Dichtungselemente angebracht, welche mit der Plattenoberfläche in dichtendem Kontakt gehalten sind, so daß das Gehäuse mit den Auftrag- und Absaugvorrichtungen mit der Plattenoberfläche einen zur Umgebung hin abgedichteten Raum bildet. Damit wird die Saugleistung der Absaugvorrichtungen zum Absaugen und Entfernen des Behandlungsmediums von der Plattenoberfläche optimal genutzt und eine besonders vollständige Entfernung des Behandlungsmediums von der Plattenoberfläche erhalten. Die bis jetzt vorgestellten Maßnahmen bei der erfindungsgemäßen Vorrichtung liefern ein vorzügliches Ergebnis, wenn die Leiterplatten die maximal mögliche Breite aufweisen und damit der Arbeitsbreite der Gesamtanlage entsprechen.

Im Falle, daß eine erfindungsgemäße Vorrichtung für die Behandlung von Platten mit wechselnder Breite verwendbar sein soll, empfiehlt es sich, auf der dem Gehäuse mit der Auftrag- und den Absaugvorrichtungen gegenüberliegenden Seite der Transportebene eine mit dem Gehäuse zusammenwirkende Abdichtvorrichtung anzuordnen, so daß nicht mehr das Gehäuse mit Plattenoberfläche einen im wesentlichen geschlossenen Raum bilden muß, sondern daß dieser bereits durch das Gehäuse und die auf der gegenüberliegenden Seite angeordnete Abdichtvorrichtung gebildet wird. Somit läßt sich in diesem Raum unabhängig von der Breite der gerade zu behandelnden Leiterplatten ein gegenüber der Umgebung im wesentlichen abgeschlossener Raum erhalten, in dem ein Unterdruck aufrechterhalten werden kann. Ein unbeabsichtigtes Austreten von flüssigen Behandlungsmedien wird damit auf ein Minimum beschränkt. Die Abdichtvorrichtung, die auf der gegenüberliegenden Seite der Transportebene angeordnet ist, kann beispielsweise aus drei miteinander an ihrem Umfang anliegenden Walzen bestehen, die sich über die komplette Breite der Anlage erstrecken. Die mittlere der drei Walzen sollte dabei einen etwas kleineren Umfang als die beiden anderen aufweisen oder aber mit ihrer Drehachse etwas weiter von der Transportebene entfernt angeordnet sein als die beiden benachbarten Walzen.

Durch diese Anordnung wird im wesentlichen verhindert, daß Luft frei zu dem Raum zutreten kann, wenn die Leiterplatten nicht die gesamte Arbeitsbreite der Anlage ausfüllen oder wenn die Leiterplatten eine Vielzahl von Bohrungen aufweisen.

Die Dichtungselemente des Gehäuses weisen vorzugsweise Bürstensegmente auf, die normalerweise dichtend am Umfang der auf der gegenüberliegenden Seite angeordneten Walzen der Abdichtvorrichtung anliegen. Diese geben in dem Bereich, in dem die Leiterplatte durchtritt, den Weg für die Leiterplatte frei.

Alternativ hierzu können die Dichtungselemente Quetschwalzen umfassen, die zum einen mit einer Dichtlippe gegenüber dem Gehäuse abgedichtet sind und zum anderen auf der Oberfläche der Platte bzw. in den Fällen, in denen keine Leiterplatte in die Vorrichtung eingefahren ist, auf der gegenüberliegenden Walze der Abdichtvorrichtung aufliegen.

Bisher wurde die Anordnung der Auftrag- und Absaugvorrichtung auf einer Seite der Transportebene besprochen. Es können die Auftrag- und Absaugvorrichtungen als zweite Einheit auch auf der gegenüberliegenden Seite der Transportebene zusätzlich angeordnet sein.

Falls eine Behandlung der Leiterplatte an der Unterseite mit der erfindungsgemäßen Konstruktion erfolgen sollte, empfiehlt es sich, die Vorrichtung als stehende Welle auszubilden, wobei dann der Raum unterhalb der Leiterplatte im wesentlichen vollständig mit Medium ausgefüllt ist und die Leiterplatte in ihrem gesamten Bereich, mit dem sie sich zwischen den Absaugvorrichtungen befindet, von der Behandlungsflüssigkeit benetzt wird.

Dabei kann vorgesehen sein, daß die Auftrag- und Absaugvorrichtungen oberhalb und unterhalb der Transportebene sich direkt gegenüberliegend angeordnet sind, so daß die die Auftrag- und Absaugvorrichtungen umgreifenden Gehäuse miteinander in dichtendem Kontakt stehen und damit die Abdichtvorrichtung, die sonst jeweils gegenüberliegend angeordnet sein soll, ersetzen können.

Alternativ kann vorgesehen sein, daß die oberhalb und unterhalb der Transportebene angeordneten Auftrag- und Absaugvorrichtungen in Transportrichtung versetzt zueinander angeordnet sind. Dies läßt insbesondere zu, unterhalb der Transportebene beispielsweise eine stehende Welle anzuordnen, während oberhalb der Transportebene die Behandlung der Plattenoberfläche mit einer Schwalldüse oder Sprühdüse als Auftragvorrichtung durchgeführt wird.

Das Problem des Verlustes der Effektivität der Absaugvorrichtungen bei variierenden Breiten der Leiterplatten kann auch dadurch begrenzt werden, daß man die Arbeitsbreite der Absaugvorrichtungen jeweils mittels einer variablen Abdeckung der Ansaugöffnungen auf die Breite der zu behandelnden Platten einstellt. Damit kann die Abdichtvorrichtung auf der gegenüberliegenden Seite der Transportebene entfallen.

Eine der vorteilhaften Ausgestaltungen der variablen Abdeckung liegt darin, daß diese ein flexibles, flüssigkeitsdichtes und an der Ansaugöffnung teilweise anliegendes Band mit einer langgestreckten, fensterartigen Öffnung umfaßt, wobei der Bereich der Überlappung der fensterartigen Öffnung des Bandes mit der Ansaugöffnung einstellbar ist.

Die Einstellung der Arbeitsbreite der Ansaugöffnung geschieht dadurch, daß die fensterartige Öffnung bzw. der geschlossene Teil des Bandes einen mehr oder weniger großen Teil der Ansaugöffnung überlappt.

Das Band kann auf zwei Rollen aufgewickelt sein und zwischen diesen beiden Rollen hin und her gespult werden und so einen größeren oder weniger groß ausfallenden Anteil der Ansaugöffnung freigeben bzw. abdecken.

Alternativ kann das Band als Endlosband ausgebildet sein, so daß ein Antrieb auf eine der notwendigen Umlenkwalzen beschränkt werden kann.

Vorteilhafterweise werden jeder Absaugvorrichtung zwei Bänder zugeordnet, die jeweils vom Randbereich der Transportebene her die Ansaugöffnungen verschließen, so daß Leiterplatten, die schmaler sind als die maximale Arbeitsbreite der Vorrichtung in beliebiger relativer Anordnung bezüglich der Arbeitsbreite durch die Maschine geschleust werden können. Die Bänder sind dabei gegenläufig antreibbar auszubilden.

Zwar ist es möglich, die Bänder von Hand anzutreiben und die entsprechende Breite der Ansaugöffnungen festzulegen, vorteilhafterweise wird dies jedoch einer automatischen Steuervorrichtung übertragen, die einen Sensor zur Erfassung der Plattenbreite und der Position der Platte in der Transportebene umfaßt. Die Steuervorrichtung wird dann in Abhängigkeit des Sensorsignales Stellsignale erzeugen, die der variablen Abdeckvorrichtung zugeführt werden und diese veranlassen, die Bänder von den Randbereichen her über die Ansaugöffnung zu schieben, so daß der noch offene Teil der Ansaugöffnungen exakt die Breite der Platten aufweist und in Querrichtung zum Transportweg relativ der Position der Platte entspricht.

Eine alternative Möglichkeit der variablen Abdichtung der Ansaugöffnungen der Absaugvorrichtungen besteht darin, daß man die variable Abdeckung mit einer Vielzahl von Abdichtelementen ausstattet, welche beim Passieren der Platten durch die Vorrichtung von einer Schließ- in eine Offenstellung bewegbar sind, so daß die Ansaugöffnung der Absaugvorrichtungen im wesentlichen nur im Bereich der Platte freigegeben ist. Damit kann die Platte mit ihrer vorlaufenden Kante die Freigabe eines Spaltes zwischen der Ansaugöffnung und der Abdichtvorrichtung bewirken, wobei die Bereiche der Ansaugöffnung, die nicht von der Plattenoberfläche bedeckt werden, von der variablen Abdeckung verschlossen bleiben. Diese Art der variablen Abdeckung hat den besonderen Vorteil, daß sie keine aufwendige Steuervorrichtung benötigt und sich sowohl auf die Plattenbreite als auch auf die Plattenposition bezüglich der Transportebene automatisch einstellt. Außerdem sind die Ansaugöffnungen in dem Augenblick verschlossen, in dem keine Leiterplatte mehr durch die Vorrichtung hindurchläuft.

Die Abdichtelemente können um eine gemeinsame Achse verschwenkbar ausgebildet sein. Vorzugsweise werden die Abdichtelemente mit einer leichten Vorspannung gegen die Ansaugöffnung gedrückt, so daß ein sicheres Verschließen der Ansaugöffnung gewährleistet ist in dem Augenblick, in dem die Platte die Ansaugöffnung freigegeben hat.

Die Abdichtelemente können hebelartig ausgeführt sein oder aber als ring- oder scheibenförmige Körper.

Dabei können auch diese Körper gegen die Ansaugöffnung vorgespannt sein, beispielsweise durch eine Vielzahl von Blattfedern, oder aber beispielsweise auch durch das Aufschwimmen in einer Flüssigkeit oder durch deren Eigengewicht.

Diese und weitere Vorteile der Erfindung werden im folgenden anhand der Zeichnungen noch näher erläutert.

Es Zeigen im einzelnen:
- Fig. 1: eine schematische Schnittansicht durch eine erfindungsgemäße Vorrichtung;
- Fig. 2: eine Detailansicht der Vorrichtung gemäß Fig. 1;
- Fig. 3: eine Variante einer Auftrag- und Absaugvorrichtung gemäß der Erfindung;
- Fig. 4: eine spiegelbildlich angeordnete Vorrichtung zum Auftragen und Absaugen des Behandlungsmediums oberhalb und unterhalb der Transportebene;
- Fig. 5: eine erfindungsgemäße Vorrichtung zum Variieren der Arbeitsbreite der Vorrichtung;
- Fig. 6: eine alternative Ausführungsform zum Variieren der Arbeitsbreite der erfindungsgemäßen Vorrichtung;
- Fig. 7: eine weitere Variante zur Anpassung der Arbeitsbreite der erfindungsgemäßen Vorrichtung

und
- Fig. 8: eine zusätzliche Variante zur Einstellung der Arbeitsbreite der erfindungsgemäßen Vorrichtung.

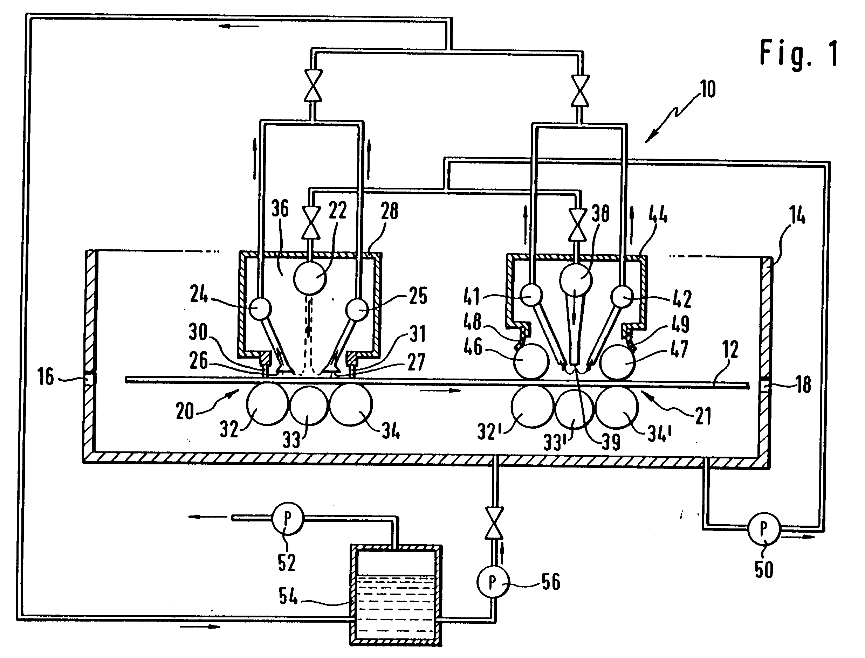

Fig. 1 zeigt eine schematische Schnittansicht einer erfindungsgemäßen Gesamtvorrichtung 10 parallel zur Transportrichtung von Leiterplatten 12, die in der Vorrichtung mit einer Behandlungsflüssigkeit, beispielsweise zum Reinigen, Ätzen, Metallisieren usw., beaufschlagt werden.

Der Transportweg der Leiterplatten 12 durch die Gesamtvorrichtung 10 wird durch eine Transportvorrichtung definiert, die hier der Einfachheit und der Übersichtlichkeit halber nicht näher dargestellt ist.

Die Leiterplatten treten in ein Gehäuse 14 der Gesamtvorrichtung 10 durch einen Eintrittsspalt 16 ein und verlassen das Gehäuse 14 der Vorrichtung 10 am gegenüberliegenden Ende durch den Austrittsspalt 18.

Auf ihrem Weg vom Eintrittsspalt 16 zum Austrittsspalt 18 werden die Leiterplatten 12 in zwei Behandlungszonen 20, 21 mit einer Behandlungsflüssigkeit beaufschlagt, wobei Fig. 1 zwei verschiedene Varianten einer erfindungsgemäßen Ausgestaltung zeigt. Es können auch nur eine Behandlungszone oder drei oder mehr Behandlungszonen innerhalb eines Gehäuses 14 angeordnet sein.

Die konstruktive Ausgestaltung der beiden Behandlungszonen 20, 21 ist hier nur zum Zwecke der Erläuterung mehrerer Ausführungsformen der Erfindung unterschiedlich gestaltet und kann selbstverständlich identisch sein oder kann eine umgekehrte Anordnung in Transportrichtung gesehen erfahren.

Die Behandlungszone 20 wird durch ein Sprührohr 22 als Auftragvorrichtung sowie zwei Saugdüsen 24, 25 als Absaugvorrichtungen definiert. Das Sprührohr 22 ist oberhalb der Transportebene der Leiterplatten 12 angeordnet und verteilt in einem flachen Strahl auf einen kleinen Bereich der Leiterplatte - in Transportrichtung gesehen - die Behandlungsflüssigkeit. In Transportrichtung gesehen vor und nach dem Sprührohr 22 nehmen die Saugdüsen 24, 25 mit ihren der Leiterplattenoberfläche zugewandten Ansaugöffnungen 26, 27 die Behandlungsflüssigkeit von der Leiterplattenoberfläche auf.

Um ein unbeabsichtigtes Austreten des Behandlungsmediums, das häufig genug eine aggresive Behandlungsflüssigkeit ist, zu vermeiden und zur Verstärkung des Saugeffekts der beiden Saugdüsen 24, 25 werden das Sprührohr 22 und die Saugdüsen 24, 25 in einem gemeinsamen Gehäuse oder einer Abdeckhaube 28 untergebracht, welches gegenüber der Oberfläche der Leiterplatte 12 mittels Bürstensegmenten 30, 31 dichtend anliegt.

Auf der zur Abdeckhaube 28 gegenüberliegenden Seite der Transportebene ist eine Abdichtvorrichtung in Form dreier an ihrem Umfang aneinander anliegenden Walzen 32, 33, 34 angeordnet. Der Radius der Walze 33 ist etwas kleiner als der Radius der Walzen 32 und 34, und die Umfangsfläche der Walze 33 hält einen Abstand zur Transportebene der Vorrichtung, so daß sie die Unterseite der Leiterplatte 12 nicht berührt.

Die Walzen 32 und 34 können, da sie die Transportebene tangieren, zum Transport der Leiterplatten durch die Vorrichtung mitbenutzt werden und stellen somit einen Teil der Transportvorrichtung dar. Der Antrieb der Walzen 32 und 34 kann beispielsweise zentral durch die Walze 33 erfolgen, es kann jedoch auch vorgesehen sein, daß die Walzen 32 und 34 lediglich als Schleppwalzen ausgebildet werden und die Walze 33 beim Durchlaufen der Leiterplatten 12 mit in Drehung versetzen. Es sollte in diesem Fall dann mindestens eine weitere Antriebswalze entlang des Transportweges der Vorrichtung vorgesehen sein. Die Abdichtwalzen 32, 33 und 34 wirken mit dem Bürstensegementen 30, 31 zusammen und erstrecken sich über die gesamte Arbeitsbreite der Vorrichtung ebenso wie die Abdeckhaube 28.

Sie bilden zusammen mit der Abdeckhaube einen evakuierbaren Raum 36, in dem aufgrund der Abdichtmaßnahmen ein leichter Unterdruck aufrechterhaltbar ist. Durch diese Maßnahme kann ein Unterdruck im Raum 36 auch dann aufrechterhalten werden, wenn Leiterplatten mit einer geringeren Breite als die maximale Arbeitsbreite der Vorrichtung durch die Vorrichtung transportiert werden. Die Effizienz der Saugdüsen 24, 25 bleibt damit unabhängig von der gerade verarbeiteten Plattenbreite im wesentlichen konstant.

Die Behandlungszone 21 ist im Prinzip ähnlich aufgebaut wie die Behandlungszone 20, wobei jedoch anstelle des Sprührohrs 22 eine schlitzförmige Schwalldüse 38 tritt. Diese endet mit ihrer Auslaßöffnung 39 nur wenig oberhalb der Leiterplattenoberfläche, und der Flüssigkeitsstrahl teilt sich in zwei Teilströme, die parallel und antiparallel zur Transportrichtung verlaufen und von Saugdüsen 41, 42 aufgenommen werden.

Auch bei dieser Anordnung ist eine Abdeckhaube 44 vorgesehen, die gegenüber der Oberfläche der Leiterplatte 12 beispielsweise mit Bürstensegmenten abgedichtet sein kann, wie dies im Fall der Behandlungszone 20 gezeigt ist. Alternativ kann jedoch auch eine andere Form der Abdichtung erfolgen, und diese Art der Abdichtung ließe sich auch auf die Ausführungsform der Behandlungszone 20 übertragen.

Das Gehäuse 44 ist gegenüber der Leiterplatte mittels Quetschwalzen 46, 47 abgedichtet, deren Drehachsen bevorzugt vertikal versetzt und parallel zu den Drehachsen der auf der gegenüberliegenden Seite der Transportebene angeordneten Abdichtwalzen 32′, 34′ angeordnet sind. Die Funktion der Abdichtwalzen 32′, 33′, 34′ ist dieselbe wie die der Abdichtwalzen 32, 33, 34, so daß hierauf nicht näher eingegangen werden muß. Ein dichtender Übergang von dem Gehäuse 44 zu den Quetschwalzen 46, 47 wird durch Dichtlippen 48, 49 gebildet, die federnd am Umfang der Walzen 46, 47 anliegen.

Im vorliegenden Beispiel werden die Leiterplatten 12 in den Behandlungszonen 20 und 21 mit derselben Flüssigkeit beaufschlagt, so daß das Gehäuse 14 für die Behandlungsflüssigkeit und die beiden Behandlungszonen 20 und 21 einen gemeinsamen Sumpf bilden kann.

Von diesem Sumpf wird die gegebenenfalls regenerierte Behandlungsflüssigkeit über die Pumpe 50 abgezogen und den Auftragvorrichtungen, nämlich dem Sprührohr 22 und der Schwalldüse 38, in den Behandlungszonen 20 bzw. 21 zugeführt.

Die Absaugung über die Saugdüsen 24, 25 und 41, 42 kann ebenfalls über eine gemeinsame Vakuumpumpe 52 geschehen, der ein Behälter 54 stromaufwärts vorgeschaltet wird, der der Abtrennung von abgesaugten Flüssigkeits- und Luftanteilen dient. Aus dem Behälter 54 wird dann über eine weitere Pumpe 56 das Behandlungsmedium in den gemeinsamen Sumpf im Gehäuse 14 zurückgeführt.

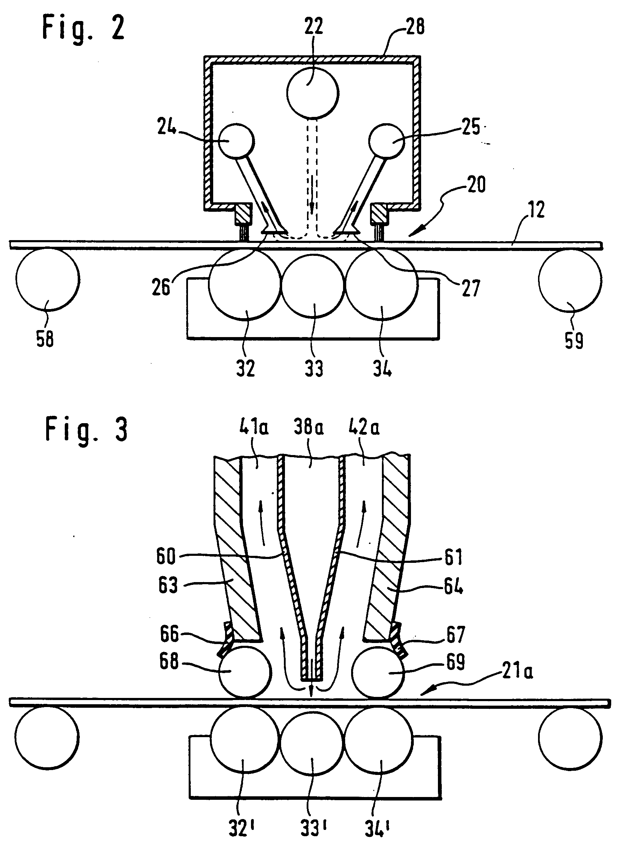

Fig. 2 zeigt die Behandlungszone 20 aus Fig. 1 in etwas größeren Details. Die Rollen 58, 59 stützen die Leiterplatte 12 in Transportrichtung gesehen vor und nach dem Passieren der Behandlungszone 20 und bilden ein Teil der ansonsten nicht weiter dargestellten Transportvorrichtung.

Aus der Figur wird deutlich, wie die in Richtung zur Leiterplattenoberfläche hin erweiterten Ansaugöffnungen 26, 27 die Flüssigkeit von der Plattenoberfläche aufnehmen und so für einen exakt definierbaren Leiterplattenbereich sorgen, der zu einem jeweiligen Zeitpunkt der Behandlung mit der Flüssigkeit unterworfen wird.

Der aus dem Sprührohr 22 austretende Flüssigkeitsstrahl ist als in Transportrichtung sehr scharf gebündelter Strahl dargestellt. Es gönnen auch weiter aufgefächerte Sprühstrahlen Verwendung finden.

Fig. 3 zeigt im Detail eine Behandlungszone 21a, die von ihrem prinzipiellen Aufbau her identisch ist mit dem Aufbau der Behandlungszone 21. Die Ausführungsform in Fig. 3 macht deutlich, daß bei einer bevorzugten Ausführungsform das Gehäuse 44 der Behandlungszone 21 zusammenfallen kann mit Wandungen der Saugdüsen 41, 42, wobei dann eine integrierte Schwall-/Saugdüsenanordnung aus den Saugkanälen 41a, 42a sowie der Schwalldüse 38a vorliegt. Während die Schwalldüse 38a bis nahe zur Oberfläche der Leiterplatte geführt ist, wird die Ansaugöffnung der Saugdüsen 41a, 42 zum einen durch die Wandungen 60, 61 der Schwalldüse 38a und andererseits durch die Wandungen 63, 64, die zur Leiterplatte hin über Dichtlippen 66, 67 und Quetschwalzen 68, 69 abschließen, gebildet.

Der restliche Aufbau entspricht dem der Behandlungszone 21 in Fig. 1, weshalb zur näheren Erläuterung auf diese Figurenbeschreibung hingewiesen werden kann.

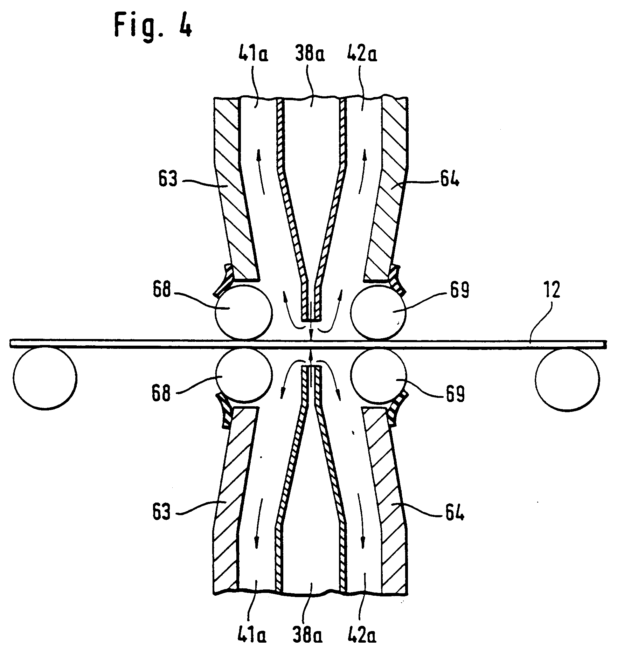

Fig. 4 zeigt die spiegelbildliche Anordnung zweier Behandlungszonen 21a oberhalb und unterhalb der Transportebene, so daß gleichzeitig die Ober- und die Unterseite der Leiterplatte behandelt werden können und wobei außerdem die ansonsten auf der gegenüberliegenden Seite notwendig werdenden Abdichtwalzen 32′, 33′, 34′ entfallen.

Bei Leiterplatten, die Bohrungen aufweisen, ist es möglich, diese gleichzeitig mit dem Rest der Leiterplattenoberfläche zu reinigen bzw. zu ätzen, falls dies erwünscht ist, oder in einer gesonderten Behandlungszone eine spezielle Bohrlochreinigung vorzunehmen.

Dem Problem des Leistungsverlustes der Absaugvorrichtungen in den Fällen, in denen Leiterplatten verarbeitet werden, deren Breite kleiner ist als die maximale Arbeitsbreite der Vorrichtung, kann auch dadurch begegnet werden, daß die Ansaugöffnungen der Absaugvorrichtungen so weit geschlossen werden, daß sie noch eine Öffnung freilassen, die der Breite der zu verarbeitenden Leiterplatten entspricht. In diesem Falle kann dann gegebenenfalls die Abdeckhaube, die die Auftrag- und Absaugvorrichtungen umschließt, entfallen und ebenso die Abdichtvorrichtung auf der gegenüberliegenden Seite der Transportebene.

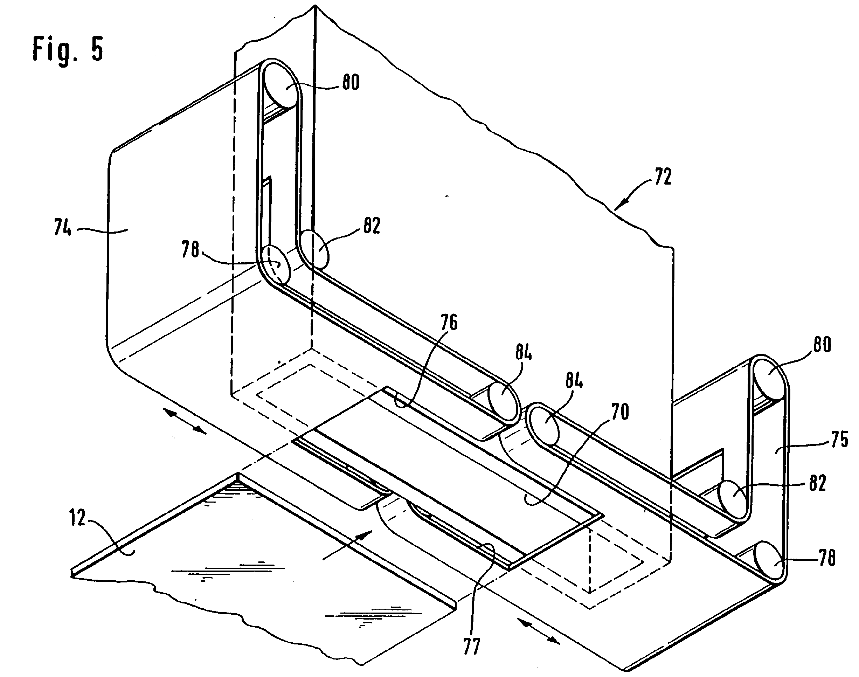

Fig. 5 zeigt eine der möglichen Lösungen für das Problem der Anpassung der Breite an einer schematisch dargestellten Saugdüse 72 mit einer Ansaugöffnung 70, wobei diese Konstruktion auf alle zuvor besprochenen Konstruktionen der Behandlungszonen 20 und 21 anwendbar ist.

Im Falle der in Fig. 3 gezeigten Behandlungszone ergibt sich dann zusätzlich noch eine Abdeckung der Auftragvorrichtung, so daß der Austritt der Behandlungsflüssigkeit ebenfalls auf den Bereich, der von der Leiterplatte überstrichen wird, beschränkt wird.

An der Unterseite der Düse 72 sind zwei Endlosbänder 74, 75 angeordnet, wobei ein Teil eines Trums parallel zur Ebene der Ansaugöffnung 70 geführt ist und außerdem an dieser zumindest partiell dichtend anliegt.

Die Endlosbänder 74, 75 weisen fensterartige Öffnungen 76, 77 auf, welche sich parallel zur Umlaufrichtung des Bandes erstrecken. Die beiden Endlosbänder 74, 75 sind symmetrisch zum Transportweg und zur Düse 72 angeordnet und werden jeweils über mehrere Rollen umgelenkt. Dabei ist eine erste Umlenkrolle 78 seitlich des Transportweges angeordnet, wobei ihre Umfangsfläche ungefähr in Höhe der Transportebene der Platten angeordnet ist.

Die Umlenkrollen 78 lenken das Band aus der Transportebene in die Vertikale um, wobei oberhalb der Transportebene Umlenkrollen 80 das Band wieder in Richtung zur Transportebene zurückführen. Kurz oberhalb der Transportebene werden die Bänder von der Rolle 80 kommend erneut durch eine weitere Umlenkrolle 82 um 90° umgelenkt, so daß dieser Teil des Endlosbandes 74 bzw. 75 parallel zur Transportebene und in Richtung zur Mitte des Transportweges verläuft. Ungefähr mittig zur Arbeitsbreite sind schließlich weitere Umlenkrollen 84 angeordnet, die das Band um 180° umlenken in Richtung zum jeweiligen Rand des Transportweges.

Der Fensterteil 76, 77 der Bänder 74, 75 kann mit verschiedenem Überlappungsgrad mit der Öffnung 70 der Saugdüse 72 angeordnet werden, so daß sich eine mehr oder weniger große Restöffnung der Ansaugöffnung 70 ergibt.

Mindestens eine der Rollen 78, 80, 82, 84 wird antreibbar sein, so daß das Endlosband durch ein Antreiben des Bandes in die eine oder andere Richtung die Überlappung der Fensterteile 76, 77 mit der Ansaugöffnung vergrößert bzw. verkleinert.

Die Bänder 74 und 75 können sowohl synchron als auch unabhängig voneinander betrieben werden, wodurch sich eine genaue Anpassung der Restöffnung der Ansaugöffnung 70 auf die jeweilige individuelle Lage einer Leiterplatte 12 in der Transportebene bewerkstelligen läßt.

Vorzugsweise wird eine solche Art der Anpassung der Arbeitsbreite der Vorrichtung mit einer elektronischen Steuerung verknüpft, welche über Sensoren die notwendige Arbeitsbreite und die relative Lage der Platten bezüglich der Transportebene feststellt und danach Signale erzeugt, über die die Endlosbänder 74, 75 so bewegt werden, daß eine zur Plattenbreite korrespondierende Arbeitsbreite auch relativ zur Breite des Transportweges gesehen in exakter Position erhalten wird.

Es ist vorteilhaft möglich, anstelle des Endlosbandes 74 bzw. 75 ein offenes Band zu verwenden, das teilweise geschlossen und teilweise eine fensterartige Öffnung aufweist, wobei die jeweiligen Enden des Bandes auf separaten Rollen aufgewickelt und beim Verändern der Arbeitsbreite von der einen auf die andere Rolle umgespult werden.

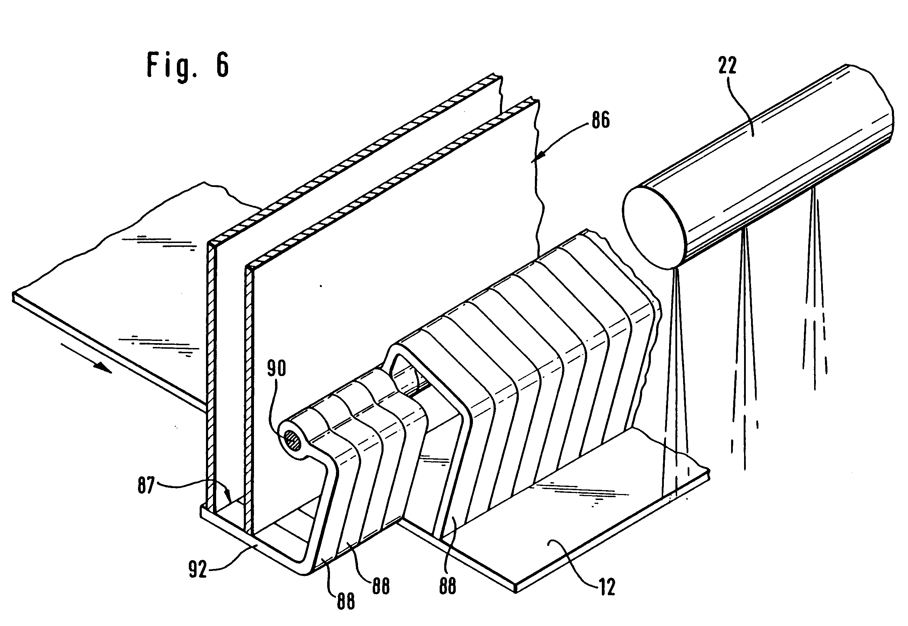

Die Fig. 6, 7 und 8 zeigen alternative Lösungen für eine Anpassung der Arbeitsbreite der Saugdüsen an die Breite der zu behandelnden Leiterplatten, wobei diese Lösungen den Vorteil haben, daß jeweils die zu bearbeitende Leiterplatte selbst eine entsprechende Einstellung der Breite der Ansaugöffnung bewirkt.

In Fig. 6 sind in Transportrichtung gesehen nachfolgend zur Saugdüse 86 verschwenkbar gehaltene, hebelartige Abdichtelemente 88 gezeigt, die unabhängig voneinander jeweils um eine Achse 90 verschwenkbar gehalten sind. Solange keine Leiterplatte 12 in die Vorrichtung einläuft, decken die Abdichtelemente 88 mit ihrem freien Ende 92 die Öffnung 87 der Saugdüse 86 ab und verhindern so einen Leistungsverlust der Saugvorrichtung insgesamt.

Die in die Vorrichtung einlaufende Leiterplatte trifft mit ihrer vorlaufenden Kante auf die freien Enden 92 eines Teils der Abdichtelemente 88 und verschwenkt diese in Transportrichtung sowie nach oben, wobei gleichzeitig partiell die Ansaugöffnung 87 der Saugdüse 86 freigegeben wird. Diese Situation ist in der Fig. 6 gezeigt.

Die Abdichtelemente 88 kehren aufgrund der Schwerkraftwirkung oder aufgrund von einer Vorspannung in ihre Ausgangslage zurück, sobald die Leiterplatte 12 durch die Vorrichtung hindurchgelaufen ist. Die Auftragvorrichtung ist in Form der Sprühdüse 22 nur schematisch dargestellt und kann auch als Schwalldüse oder ähnliches ausgebildet sein.

Nachfolgend zur Sprühdüse 22 ist dann dieselbe Anordnung von Saugdüse 86 samt Abdichtelementen 88 vorgesehen und der Einfachheit halber jedoch in Fig. 6 nicht dargestellt.

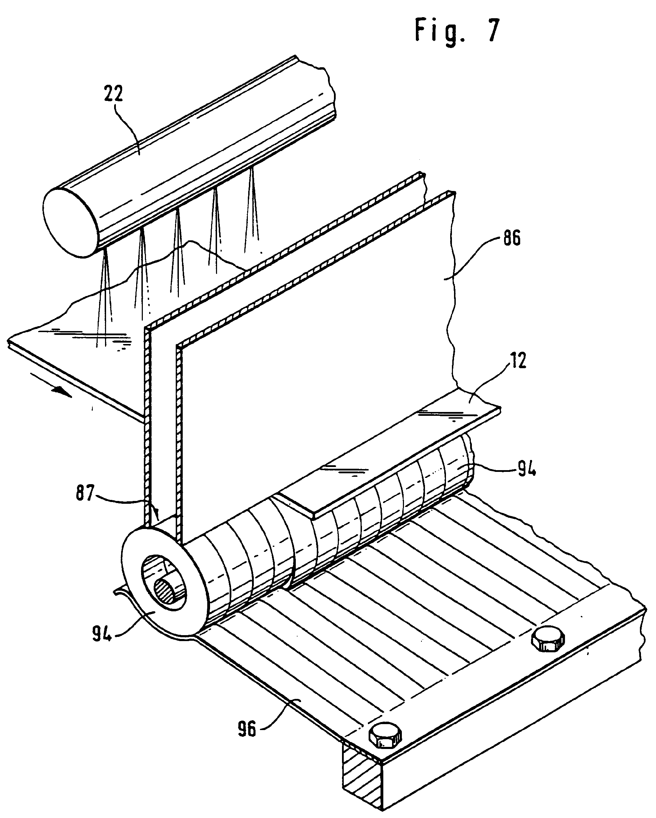

Ein ganz ähnliches Prinzip wie Fig. 6 zeigt Fig. 7, wobei jedoch dort anstelle der Abdichtelemente 88 ringförmige Abdichtelemente 94 treten, die einzeln über Federzungen 96 gegen die Ansaugöffnung 87 gedrückt werden. Sobald die Leiterplatte 12 in die Vorrichtung einfährt, werden die Dichtringe 94 von der vorlaufenden Kante der Leiterplatte 12 von der Ansaugöffnung 87 weggedrückt und geben somit die Ansaugöffnung 87 exakt in der Breite der Leiterplatte 12 frei.

Im Falle der Fig. 7 ist die in Transportrichtung der Auftragvorrichtung nachfolgende Saugdüse dargestellt, wobei die in Transportrichtung stromaufwärts angeordnete Düse dieselbe Anordnung aufweist. Sie ist nur der Einfachheit halber nicht dargestellt.

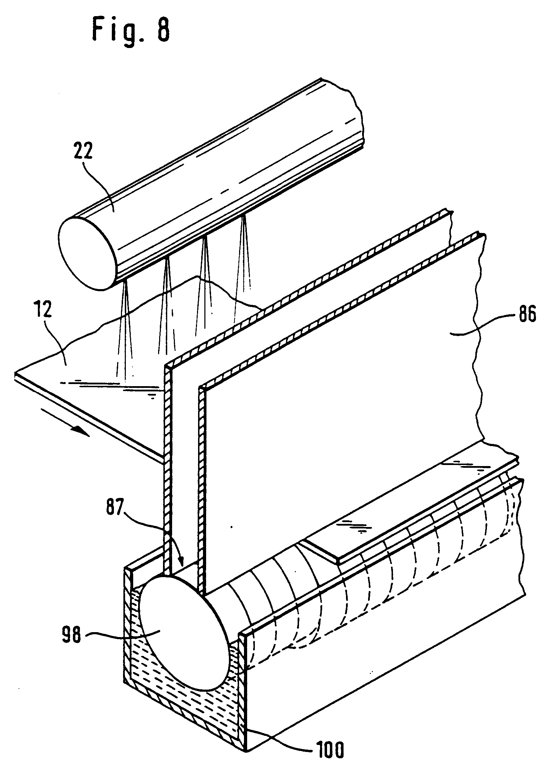

Schließlich ist in Fig. 8 eine weitere Variante dargestellt, bei der geschlossene, an ihren Außenumfang zylindrische Körper gegen die Ansaugöffnung 87 der Düse 86 gedrückt werden. Das besondere bei der Ausführungsform der Fig. 8 ist, daß die Körper 98 in einem Kanal 100 angeordnet sind, in dem sich eine den Körpern 98 Auftrieb verleihende Flüssigkeit, insbesondere das Behandlungsmedium selbst, staut und zu einem Aufschwimmen der Abdichtkörper 98 in Richtung zur Ansaugöffnung 87 führt. Beim Durchtreten der Leiterplatte 12 werden die Körper 98 von der Ansaugöffnung 87 im Bereich der Breite der Leiterplatte selbst verdrängt und lassen diese passieren.

Nachdem die Leiterplatte aus der Vorrichtung vollständig austritt, werden die Körper wiederum infolge des Auftriebs durch die in dem Kanal 100 angestaute Flüssigkeit nach oben in Richtung zur Ansaugöffnung 87 der Saugdüse 86 gedrückt und verschließen diese umgehend.

## Patentansprüche

1. Vorrichtung zum Behandeln von plattenförmigen Gegenständen, insbesondere Leiterplatten (12), mit einem fluiden Behandlungsmedium, insbesondere einer Reinigungs-, Ätz-, Metallisierungs- bzw. Spülflüssigkeit, mit einer Transportvorrichtung zum Transport der plattenförmigen Gegenstände (12) entlang eines ggf. im wesentlichen horizontalen Transportweges und mit wenigstens einer Auftragvorrichtung, wie einer Sprüh- oder Schwalldüse oder einer Vorrichtung, die eine stehende Welle erzeugt, zum Aufbringen des Behandlungsmediums, dadurch gekennzeichnet, daß Mittel (26-28; 44, 46- 49) vorgesehen sind, durch welche ein Oberflächenbereich der Platte (12), der zu einem Zeitpunkt mit dem Behandlungsmedium in Kontakt steht, in seiner Ausdehnung längs der Transportrichtung vordefinierbar und begrenzbar ist.

2. Vorrichtung nach Anspruch 1, dadurch gekennzeichnet, daß in Transportrichtung gesehen vor und nach der Auftragvorrichtung (22; 38) Absaugvorrichtungen (24; 25; 41; 42) mit der Plattenoberläche zugewandten und im wesentlichen über die gesamte Breite des Transportweges reichenden Ansaugöffnungen (26, 27) angeordnet sind, daß insbesondere eine Auftragvorrichtung (22; 38) und wenigstens eine Absaugvorrichtung (24; 25; 41; 42) in einem gemeinsamen Gehäuse (28; 44) angeordnet sind, und daß vorzugsweise das jeweilige Gehäuse (28; 44) Dichtungselemente (30; 31; 46; 47) umfaßt, welche mit der Plattenoberfläche in dichtendem Kontakt gehalten sind.

3. Vorrichtung nach Anspruch 1 oder 2, dadurch gekennzeichnet, daß auf der einem Gehäuse (28; 44) gegenüberliegenden Seite der Transportebene eine mit diesem zusammenwirkende Abdichtvorrichtung (32; 33; 34; 32′, 33′, 34′) angeordnet bzw. in dem von dem Gehäuse (28; 44) einerseits und einer Abdichtvorrichtung andererseits überspannten Breite des Transportweges ein Unterdruck aufrechterhaltbar ist, daß insbesondere Dichtungselemente Bürstensegmente umfassen und, daß vorzugsweise Dichtungselemente Quetschwalzen (46, 47) umfassen.

4. Vorrichtung nach einem der vorhergehenden Ansprüche, dadurch gekennzeichnet, daß auf beiden Seiten der Transportebene jeweils mindestens eine Auftrag- und Absaugvorrichtung (38a; 41a; 42a) angeordnet ist, daß insbesondere unterhalb der Transportebene angeordnete Auftrag- und Absaugvorrichtungen eine Abdichtvorrichtung bilden, welche mit den gegenüberliegend angeordneten Auftrag- und Absaugvorrichtungen einen evakuierbaren Raum definieren und, daß vorzugsweise oberhalb und unterhalb der Transportebene angeordnete Auftrag- und Absaugvorrichtungen in Transportrichtung versetzt zueinander angeordnet sind.

5. Vorrichtung nach einem der vorhergehenden Ansprüche, dadurch gekennzeichnet, daß die Arbeitsbreite mindestens einer Absaugvorrichtung (24; 25; 41; 42) mittels wenigstens einer variablen Abdeckung mindestens einer Ansaugöffnung auf die Breite der zu behandelnden Platten (12) einstellbar ist, daß insbesondere eine variable Abdeckung mindestens ein flexibles, flüssigkeitsdichtes, an der Ansaugöffnung (70) teilweise anliegendes Band (74; 75) mit einer langgestreckten, fensterartigen Öffnung umfaßt und der Bereich der Überlappung der fensterartigen Öffnung mit der Ansaugöffnung (70) einstellbar ist und daß vorzugsweise wenigstens ein Band als Endlosband ausgebildet ist.

6. Vorrichtung nach einem der vorhergehenden Ansprüche, dadurch gekennzeichnet, daß mindestens einer Absaugvorrichtung (72) zwei Bänder (74; 75) zugeordnet sind, deren fensterartige Öffnungen im Bereich der Ansaugöffnung (70) der Absaugvorrichtung (72) sich im wesentlichen aneinander anschließen und die insbesondere gegenläufig antreibbar sind.

7. Vorrichtung nach einem der vorhergehenden Ansprüche, dadurch gekennzeichnet, daß eine Steuervorrichtung mit wenigstens einem Sensor zur Erfassung der Werkstückbreite bzw. der Position des Werkstückes (12) in der Transportebene vorgesehen ist, wobei insbesondere die Steuervorrichtung in Abhängigkeit des Sensorsignales Stellsignale für die variable Abdeckung erzeugt.

8. Vorrichtung nach einem der vorhergehenden Ansprüche, dadurch gekennzeichnet, daß mindestens eine variable Abdeckung für wenigstens einen Flächenbegrenzer eine Vielzahl von Abdichtelementen (88) umfaßt, welche beim Passieren der Platten (12) von einer Schließ- in eine Offenstellung bewegbar sind, so daß insbesondere eine Ansaugöffnung (87) einer Absaugvorrichtung (86) im wesentlichen nur im Bereich der Platte (12) freigegeben ist.

9. Vorrichtung nach einem der vorhergehenden Ansprüche, dadurch gekennzeichnet, daß mindestens ein Abdichtelement (88), insbesondere zur Flächenbegrenzung, um eine Achse verschwenkbar ist, wobei vorzugsweise eine Mehrzahl von Abdichtelementen (88) um eine gemeinsame Achse (90) schwenkbar gelagert sind.

10. Vorrichtung nach einem der vorhergehenden Ansprüche, dadurch gekennzeichnet, daß mindestens ein Abdichtelement, insbesondere zur Flächenbegrenzung, als ring- oder scheibenförmiger Körper (98) ausgebildet und vorzugsweise jeweils einzeln vorgespannt gegen eine Ansaugöffnung (87) anlegbar ist.

## Claims

1. Apparatus for treating board-like articles, particularly printed circuit boards (12), with a fluid treatment medium, particularly a cleansing, etching, metallizing or rinsing liquid with a conveying device for conveying the board-like articles (12) along an optionally substantially horizontal conveying path and at least one applicator, such as a spray or swell nozzle or a device which produces a stationary wave, characterized in that means (26-28;44,46-49) are provided, through which a surface area of the board (12), which at a particular time is in contact with the treatment medium is predefinable and limitable in its extension along the conveying direction.

2. Apparatus according to claim 1, characterized in that, considered in the conveying direction upstream and downstream of the applicator (22;38), suction devices (24;25;41;42) are provided with suction openings (26,27) facing the board surface and extending substantially over the entire width of the conveying path, that in particular an applicator (22;38) and at least one suction device (24;25;41;42) are located in a common casing (28;44) and that preferably the particular casing (28;44) incorporates sealing elements (30;31;46;47), which are kept in sealing contact with the board surface.

3. Apparatus according to claim 1 or 2, characterized in that on the side of the conveying plane opposite to the casing (28;44) is provided a sealing device (32;33;34;32′,33′,34′) cooperating therewith or in the width of the conveying path spanned by the casing (28;44) on the one hand and a sealing device on the other it is possible to maintain a vacuum, that in particular the sealing elements comprise brush segments and that preferably the sealing elements comprise squeezing rollers (46,47).

4. Apparatus according to one of the preceding claims, characterized in that on both sides of the conveying plane is provided in each case at least one applying and suction device (38a;41a;42a), that in particular the applying and suction devices located below the conveying plane form a sealing device defining with the oppositely arranged applying and suction devices an evacuatable space and that preferably the applying and suction devices positioned above and below the conveying plane are reciprocately displaced in the conveying direction.

5. Apparatus according to one of the preceding claims, characterized in that the working width of at least one suction device (24;25;41;42) can be adjusted by means of a variable covering of at least one suction opening on the width of the boards (12) to be treated, that in particular a variable covering comprises a flexible, liquid-tight belt (74;75) partially engaging on the suction opening (70) and having an elongated, window-like opening and the area of the overlap of the window-like opening with the suction opening (70) being adjustable and that preferably at least one belt is constructed as an endless belt.

6. Apparatus according to one of the preceding claims, characterized in that with at least one suction device (72) are associated two belts (74;75), whose window-like openings are connected to one another in the vicinity of the suction opening (70) of the suction device (72) and can in particular be driven in opposite directions.

7. Apparatus according to one of the preceding claims, characterized in that a control device with at least one sensor is provided for determining the workpiece width or the position of the workpiece (12) in the conveying plane and the control device, as a function of the sensor signal, produces adjusting signals for the variable covering.

8. Apparatus according to one of the preceding claims, characterized in that at least one variable covering for at least one surface limiter comprises a plurality of sealing elements (88), which can be moved from a closed into an open position on the passage of the boards (12), so that in particular a suction opening (87) of a suction device (86) is substantially only freed in the vicinity of the board (12).

9. Apparatus according to one of the preceding claims, characterized in that at least one sealing element (88), particularly for surface limitation purposes, can be pivoted about an axis and preferably a plurality of sealing elements (88) are mounted in pivotable manner about a common axis (90).

10. Apparatus according to one of the preceding claims, characterized in that at least one sealing element, particularly for surface limitation purposes, is constructed in the form of circular or disk-shaped bodies (98) and can preferably be engaged in individually pretensioned form against the suction opening (87).

## Revendications

1. Dispositif pour traiter des objets en forme de plaques, et en particulier des plaques de circuits imprimés (12), au moyen d'un agent de traitement liquide, et en particulier d'un liquide de nettoyage, d'attaque, de métallisation ou de rinçage, respectivement, comprenant un dispositif transporteur pour déplacer les objets en forme de plaques (12) le long d'un trajet de transport, pour l'essentiel horizontal le cas échéant, et comprenant au moins un dispositif d'application, comme une buse de pulvérisation ou à jet ou un dispositif qui engendre une circulation constante, en vue d'appliquer l'agent de traitement, caractérisé par le fait qu'il est prévu des moyens (26 à 28 ; 44, 46 à 49) grâce auxquels une zone de la surface de la plaque (12) qui est en contact avec l'agent de traitement à un instant donné peut être définie au préalable et délimitée dans son étendue dans le sens longitudinal par rapport à la direction de transport.

2. Dispositif selon la revendication 1, caractérisé par le fait qu'en amont et en aval du dispositif d'application (22 ; 38) dans la direction de transport sont disposés des dispositifs d'aspiration (24 ; 25 ; 41 42) qui sont pourvus d'ouvertures d'aspiration (26, 27) tournées vers la surface de la plaque et qui s'étendent pour l'essentiel sur toute la largeur du trajet de transport, par le fait qu'en particulier, un dispositif d'application (22 ; 38) et au moins un dispositif d'aspiration (24 ;25 ;41 ; 42) sont disposés dans un carter commun (28 ; 44), et par le fait que le carter correspondant (28 ; 44) comporte de préférence des organes d'étanchéité (30 ;31 ; 48 ; 47) qui sont maintenus en contact étanche avec la surface de la plaque.

3. Dispositif selon la revendication 1 ou 2, caractérisé par le fait qu'un dispositif d'étanchéité (32 ; 33 ; 34; 32′ ; 33′ , 34′) qui coopère avec un carter (28 ; 44) est disposé sur le côté du plan de transport qui est opposé à celui-ci, ou, respectivement, qu'une dépression peut être maintenue sur la largeur du trajet de transport qui est recouverte par le carter (28 ; 44), d'une part, et, d'autre part, par un dispositif d'étanchéité, par le fait qu'en particulier, les organes d'étanchéité comprennent des éléments en forme de brosses, et par le fait que, de préférence, les organes d'étanchéité comprennent des rouleaux à écrasement (46, 47).

4. Dispositif selon l'une des revendications précédentes, caractérisé par le fait qu'au moins un dispositif d'application et d'aspiration (38a ; 41a ; 42a) est à chaque fois disposé des deux côtés du plan de transport, par le fait qu'en particulier, des dispositifs d'application et d'aspiration disposés au-dessous du plan de transport forment un dispositif d'étanchéité qui définit avec les dispositifs d'étanchéité disposés à l'opposé un volume qui peut être mis sous vide, et par le fait que, de préférence, des dispositifs d'application et d'aspiration situés au-dessus et au-dessous du plan de transport sont disposés en étant décalés les uns par rapport aux autres dans la direction du transport.

5. Dispositif selon l'une des revendications précédentes, caractérisé par le fait que la largeur de travail d'au moins un dispositif d'aspiration (24 ; 25 ; 41 ; 42) peut être réglée sur la largeur des plaques à traiter (12) au moyen d'au moins un recouvrement variable d'au moins une ouverture d'aspiration, par le fait qu'en particulier, un recouvrement variable comporte au moins une bande flexible et étanche aux liquides (74 75) qui porte partiellement sur l'ouverture d'aspiration (70) et qui présente une ouverture allongée analogue à une fenêtre, la zone du recouvrement de l'ouverture analogue à une fenêtre par l'ouverture d'aspiration (70) étant réglable, et par le fait que, de préférence, au moins une bande est réalisée sous la forme d'une bande sans fin.

6. Dispositif selon l'une des revendications précédentes, caractérisé par le fait que sont associées à au moins un dispositif d'aspiration (72) deux bandes (74 ; 75) dont les ouvertures analogues à des fenêtres se raccordent entre elles dans la région de l'ouverture d'aspiration (70) du dispositif d'aspiration (72), pour l'essentiel, et qui peuvent être entraînées en particulier dans des sens opposés.

7. Dispositif selon l'une des revendications précédentes, caractérisé par le fait qu'il est prévu un dispositif de commande pourvu d'au moins un capteur pour déterminer la largeur de la pièce ou, respectivement, la position de la pièce (12) dans le plan de transport, le dispositif de commande engendrant en particulier des signaux d'asservissement pour faire varier le recouvrement en fonction du signal du capteur.

8. Dispositif selon l'une des revendications précédentes, caractérisé par le fait qu'au moins un recouvrement variable destiné à au moins un limiteur de surface comporte une pluralité d'éléments d'étanchéité (88) qui peuvent être déplacés depuis une position de fermeture jusque dans une position d'ouverture lors du passage des plaques (12), de sorte qu'en particulier, une ouverture d'aspiration (87) d'un dispositif d'aspiration (86) n'est libérée pour l'essentiel que dans la région de la plaque (12).

9. Dispositif selon l'une des revendications précédentes, caractérisé par le fait qu'au moins un élément d'étanchéité (88), destiné en particulier à limiter la surface, peut pivoter autour d'un axe, une pluralité d'éléments d'étanchéité (88) étant de préférence montés pivotants autour d'un axe commun (90).

10. Dispositif selon l'une des revendications précédentes, caractérisé par le fait qu'au moins un élément d'étanchéité, destiné en particulier à limiter la surface, est réalisé sous la forme d'un corps (98) en forme de bague ou de disque, et que, de préférence, il peut être posé contre une ouverture d'aspiration (87) en étant à chaque fois soumis individuellement à une force de rappel.
